# EUROPEAN PATENT SPECIFICATION

(11) **EP 2 032 244 B1**
(45) Date of publication and mention of the grant of the patent: **29.06.2016**
(21) Application number: 07766505.7
(22) Date of filing: 25.05.2007
(51) Int. Cl.: B01J 4/00, C23C 16/448

(54) **SYSTEM AND METHOD FOR DELIVERY OF PRECURSOR MATERIAL**
SYSTEM UND VERFAHREN ZUR AUSGABE EINES VORLÄUFERMATERIALS
SYSTÈME ET PROCÉDÉ DE DISTRIBUTION DE MATÉRIAU PRÉCURSEUR

(30) Priority: 01.06.2006 FR 0652003
(43) Date of publication of application: 11.03.2009
(73) Proprietor: L'AIR LIQUIDE, Société Anonyme pour l'Etude et l'Exploitation des Procédés Georges Claude, 75321 Paris Cedex 07 (FR)
(72) Inventor: RAMEAU, Guillaume, F-92100 Boulogne Billancourt (FR); LAURENT, Valere, F-38190 Villard Bonnot (FR); GIRARD, Jean-Marc, F-75009 Paris (FR)
(74) Representative: Conan, Philippe Claude
(86) International application number: PCT/IB2007/001378
(87) International publication number: WO 2007/138439

(56) References cited:
- EP-A1- 0 696 472
- EP-A2- 0 951 052
- US-A- 5 776 255

## Description

The present invention relates to a method for distributing liquid, in particular pyrophoric, products from a storage point to a use point, and an apparatus for distributing these products, comprising in particular means for condensing/melting the purified product.

The semiconductor industry is led to use novel products in order to meet the performance and miniaturization requirements of integrated circuits. These precursors are not only usable for manufacturing the semiconductors, but also in optoelectronics, for depositing layers of these products. These products include in particular metal, organometallic, silicon precursors, and precursors of nitride, carbide layers, derived or not from these products, and for the manufacture of flat screens of solar cells.

Some of these precursors, like trimethyl aluminum (TMA) or trimethyl gallium (TMGa), dimethyl zinc (DiZ), DMAH (dimethyl aluminum hydride), in particular, have the particular feature of being pyrophoric, that is, of igniting spontaneously in contact with air, and some of them also react explosively in contact with water.

In general, these products are currently employed using bubblers, that is, the products in liquid form are traversed by a gas such as, for example, an inert gas (nitrogen, argon, helium, etc.) usable in the manufacturing process, these bubblers being placed as close as possible to the semiconductor production equipment in the clean room. The product in liquid form is supplied in small prepacked bubbler receptacles which are disconnected when they become empty.

Such an operation entails numerous connections and disconnections in this clean room, of the systems which supply these precursors, incurring many risks in terms of safety, whether for the surrounding installations, or for the operators When the bubbler replacement frequency becomes too high, one solution has been provided in which these bubblers are fed by a central system for distributing the liquid product, a system which can be installed in a protected zone.

This solution has the advantage of eliminating the need for bubbler replacements in a white room, but requires routing the pressurized liquid between its protected central storage point to the various bubblers near the use point.

Various complementary methods, such as purging the lines between each filling at the bubbler use points, or the use of pressurized double jackets with an inert gas around the pressurized liquid lines, have been developed in order to further safeguard the distribution of these liquids.

However, such a method has a number of drawbacks: among these, mention can be made in particular of the fact that the bubblers can only be filled sequentially and not simultaneously, and that this overall installation incurs a rather high additional cost during the installation of the system for distributing these precursors in the production unit.

US 5776255. EP 0696472 and EP 0951052 disclose methods for bubbling a gas through a liquid product.

In general, the invention relates to the distribution of liquid products by bubbling an inert gas in a receptacle containing said liquid. The invention is suitable for purifying a liquid, in particular pyrophoric, product, thereby stripping it of at least some of its residual impurities during its transport in the distribution line.

The present invention is further suitable for routing the product, in particular pyrophoric, safely to the use point, and for providing, as close as possible to the equipment, the quantity of liquid just necessary for the immediate or virtually immediate needs of the apparatus where the semiconductors or other optoelectronic devices, flat screens, etc. are manufactured.

This serves in particular to supply a less pure (hence less costly) liquid than the one which is supplied in the bubbler receptacles in current use, while supplying

This serves in particular to supply a less pure (hence less costly) liquid than the one which is supplied in the bubbler receptacles in current use, while supplying a product with at least equivalent or higher purity than that of the products currently supplied in said bubbler receptacles. This also serves, starting with "electrical" grade products, that is, already very pure, to supply an even purer product, with improved quality.

According to the invention, this product is distributed from a storage point (which may be a central system) by bubbling an inert gas into the liquid, in particular pyrophoric, to be purified, contained in this storage unit (that is, the liquid, in particular pyrophoric, product as sold on the market) in order to generate a mixture of inert gas and product, in particular pyrophoric, the mixture of product vapors, in particular pyrophoric, diluted in the inert gas no longer being pyrophoric (and the least volatile impurities remain in the liquid). The vapors contained in the mixture are then condensed (after transport) in liquid form as close as possible to the production equipment, in order to recover the purified, in particular pyrophoric, product, optionally by passing through a phase in the solid state according to the type of precursor used, after transport of this gas mixture under adequate safety conditions over the desired distance (the transport line can also be heated to prevent the condensation of liquid during this transport).

The other components of the mixture (such as, for example, light hydrocarbons, or more volatile impurities than the precursor depending on the temperature and pressure conditions of the mixture, and also the inert gas) remain in the gas state and are removed with the gas phase from the mixture, which then essentially contains the inert gas and some of these light impurities. This is especially important in applications pertaining particularly to the field of optoelectronics.

For example, since trimethyl aluminum solidifies at 15°C, the distribution of this product in this case generally passes through a liquid phase, and then a solid phase; since trimethyl gallium has a melting point of -15°C, it is not always necessary to pass through the solid phase.

Underlying the implementation of the invention is an apparatus for separating the vapors of products, in particular pyrophoric (after transport) from the other components of the mixture and particularly the inert gases. The vapors can be condensed or even solidified using an apparatus which generates cold. The use of this apparatus to cool the transported mixture obviously represents the best compromise for implementation, because the cooling step serves both to separate the product, in particular pyrophoric, from the impurities it initially contains, and from the inert gas, and to condense it (in liquid and/or solid form).

Solidification is preferred insofar as it serves to recover nearly all the product vapors after preferably passing through a phase of product recovery in liquid form. This solidification step is only carried out when the temperatures are compatible with a moderate use of energy. (For a reasonable energy cost, temperatures of -30°C to - 40°C can easily be obtained).

In case of solidification, the solid can then be melted by heating the receptacle in which the product has been solidified or the walls thereof, in order to obtain a volume of liquid in a quantity just necessary and directly usable by the equipment. This is one important aspect of the inventive apparatus and method.

The inventive method is characterized in that an inert gas is bubbled through the product, in particular pyrophoric, to be purified in the liquid state, the mixture is preferably routed close to the use point or to a second storage point, the product, in particular pyrophoric, is then separated in liquid and/or solid form from the inert gas and from at least part of the light impurities possibly contained in the product, in particular pyrophoric, to be purified, in order to obtain a purified product, in particular pyrophoric, close to the use point. Preferably, this separation takes place using cold generating means in order to convert the gaseous product, in particular pyrophoric, to a liquid and/or solid product, in particular pyrophoric, while (generally) removing some of the impurities contained in the impure pyrophoric product.

According to various alternatives of the inventive method used alone or in combination:
- the product, in particular pyrophoric, to be purified is heated,
- the mixture of inert gas and product, in particular pyrophoric, is heated during at least part of its routing,
- the mixture is essentially heated along the whole length of its route up to the separation of the pyrophoric product and the inert gas,
- the pyrophoric product of the mixture is separated from at least the inert gas using a cryogenic condensation system, a membrane and/or an adsorption system,
- a cryogenic condensation system is used, in which the separation takes place in a first phase, during which the product in gaseous form is liquefied and recovered. In a second phase, the liquid product is optionally solidified,
- the transition from the gas phase to the liquid and/or solid phase is carried out by passage through a heat exchanger,
- the cooling in the heat exchanger takes place by indirect contact with a cooled heat transfer liquid using a compressor, or using a Peltier effect device (thermoelectric cooling),
- the solidified pyrophoric product is melted to the purified pyrophoric liquid state,
- an inert gas is injected into the liquid, in particular pyrophoric, to be purified, in order to generate a mixture of inert gas and vapors of purified liquid, which can be delivered immediately to the reactor,
- the liquid is directly vaporized in a vaporizer called a "flash" vaporizer.

An apparatus suitable for distributing the product, in particular pyrophoric, comprises:
- first means for storing an initial (impure) product to be distributed,
- means for delivering an inert gas,
- means for bubbling an inert gas into the initial product to generate vapors of mixtures of inert gas and product, in particular pyrophoric,
- means for transporting said mixture,
- means for condensing the product, in particular pyrophoric, optionally stripped of at least some of its impurities, to generate a final product, in particular pyrophoric.

The apparatus may comprise, alone or in combination, the following various features:
- the means for condensing the products, in particular pyrophoric, consist of a heat exchanger in which the mixture and a heat transfer fluid flow, preferably consisting of a coil in the form of a double jacket tube,
- the heat exchanger comprises a first portion for liquefying the product, in particular pyrophoric, in the form of a final product,
- the heat exchanger comprises a second portion for solidifying said product, in particular pyrophoric,
- second means for storing said pyrophoric final product.

Furthermore, the apparatus may comprise one or more of the following features:
- means for heating the first means for storing the initial product,
- heating means placed on at least part of the means for transporting said mixture,
- the separation of the product, in particular pyrophoric, to be purified, from the other elements of the mixture, is carried out by cryogenic cooling means comprising, in their upper part, means for removing the inert gas and at least some of the impurities constituting the mixture (those which are incondensable under the conditions used),
- distribution means for delivering the purified product, in particular pyrophoric, from the second storage means to the use point (in liquid form or in a mixture with an inert gas which is bubbled in the liquid, as explained previously).

The invention will be better understood from the following exemplary embodiments, provided as nonlimiting examples, in conjunction with the figures which show:
- Figure 1, a flowchart of the inventive method and device,
- Figure 2, a detailed view of the flowchart in Figure 1,
- Figure 3, a first exemplary embodiment of a heat exchanger configuration,
- Figure 4, an alternative of the heat exchanger in Figure 3,
- Figure 5, two other simplified configurations of a heat exchanger of the invention,
- Figure 6, another exemplary embodiment of the heat exchanger of the invention.

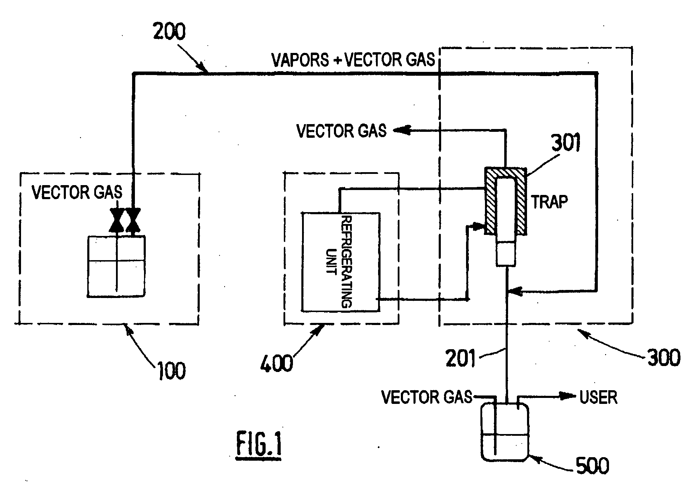

Figure 1 shows a flowchart of the distribution method and device usable in the invention.

The unit 100 comprises a receptacle 170 containing the precursor product 120 in liquid form as may be procured on the market, a receptacle (which can be heated by the means 99) into which a vector gas is injected by bubbling, the mixture of product, in particular pyrophoric, and inert vector gas being sent into the line 200 (optionally heated on part of its length by the heating resistor 40 wound around 200) which is itself connected to the line 201 whereof one end (upper part) is connected to the trap 301, said trap 301 condensing the product, in particular pyrophoric, in liquid form, said product then flowing via the line 201 into the receptacle 500 where it is stored for future use. In the case in which the product, in particular pyrophoric, is stored in the trap in solid form, this product, in particular pyrophoric, is then liquefied in the trap 301 (which comprises adequate heating means), the liquid then flowing via the line 201 into the receptacle 500. In order to obtain the condensation or solidification of the product, in particular pyrophoric, the trap is connected to a refrigerating unit 400 which, via a heat exchanger, carries out a heat exchange between the heat transfer liquid of the refrigerating unit and the vapor phase, the mixture of inert gas and pyrophoric vapor.

The receptacle 500, as shown in the diagram, comprises a system for injecting vector gas which is bubbled in the liquid with an outlet to the user located close nearby.

The apparatus which generates the cold and heat called trap (301 above) may typically comprise:
- one or more Peltier effect elements wherein the flow direction can be reversed for cooling or heating (in a manner known per se to a person skilled in the art),
- a refrigerating unit with or without a compressor, supplemented or not by an auxiliary heater of any type whatsoever (heating resistor, induction heater, halogen, forced convection, etc.).

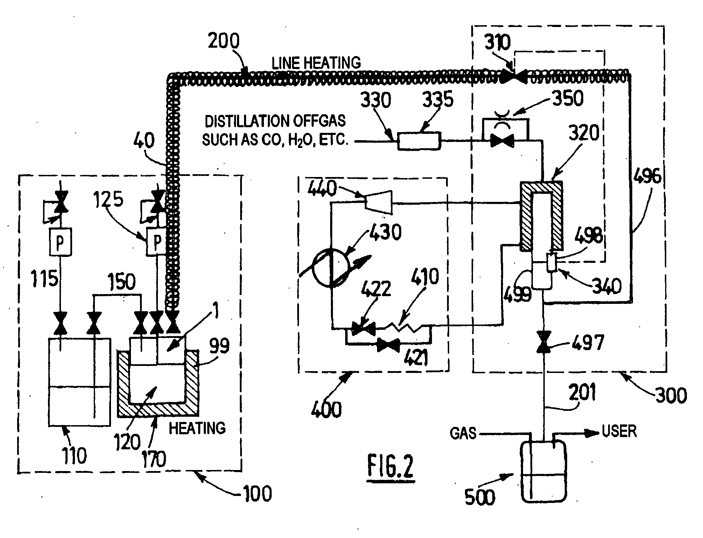

Figure 2 shows a detailed implementation of the flowchart in Figure 1.

The product vapors entrained in the vector gas enter via the valve 310 which is, for example, controlled by a level detector 340 under the trap 301 (trap or unit operating as a cold trap). The liquid recovery phase can also be controlled without a level detector using simple timers controlled by a programmable controller or a microprocessor, in a manner known per se.

The gas flow rate is controlled by an orifice 350, the pressure of the gas entering the trap 301 being controlled in the bubbler. A gas phase flow controller can also be used. The vapors enter the trap via a heat exchanger 320 which can assume all the forms known to a person skilled in the art (tube and shell, tube in tube, plate heat exchanger, etc.). This heat exchanger 320 has a dual function, the first being to liquefy and then solidify the vapors entrained in the vector gas (when the precursor has an appropriate solidification point, that is, not too low), the second function permitting the melting of the solid formed in the heat exchanger in the previous phase, in order to recover a volume of liquid directly usable by the equipment 500.

An important advantage of the invention is the use of only one fluid to provide the cold necessary for the first function (solidification) and the heat necessary for the second (melting of the solid to preferably obtain a liquid). It generally suffices to stop the operation of the compressor 430 to obtain the melting of the solid product (without even circulating any "hot" heat transfer liquid).

This is made possible by the design of the refrigerating unit 400 which incorporates two valves 421 and 422, for operating this refrigerating unit, either respectively without capillary expansion device or pressure reducer 410, or with a capillary expansion device or pressure reducer 410 (when 421 is closed and 422 is open).

The refrigerating unit then solidifies the vapors when the capillary or the pressure reducer is in service, and it melts the solid when the latter is avoided, by thereby directly connecting the compressor 440 to the heat exchanger 320 via the valve 421. The compressor 440 and the heat exchanger 430 can use the ambient air, water or any other fluid to cool the gas at the compressor outlet.

The present invention has the advantage of being easily incorporable in existing process equipment, the design of the trap 300 being such as to make it easily incorporable in the product feed unit of equipment available in a semiconductor production unit, while the refrigerating unit can be offset and simply connected by lines which transport the heat transfer liquid in contact with the trap 300.

Preferably, the pipe in which the product may be solidified in the heat exchanger system has a diameter of at least 0.5 mm to avoid rapid clogging during solidification.

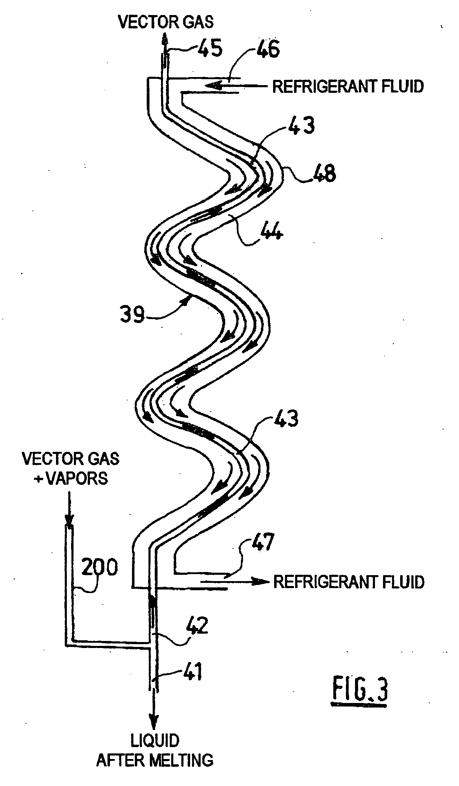

Figures 3, 4, 5 and 6 show various alternative embodiments of the heat exchanger 320 provided as nonlimiting examples. Obviously, many alternatives can be produced by a person skilled in the art, while remaining within the framework of the invention defined above.

Figure 3 shows a coil 39 supplied by the base via the lines 200 and 42 by a mixture of inert gas and pyrophoric vapor, this mixture rising through the line 42 inside a coil 39 with a double jacket 43 and 48, in which flow respectively (generally preferably in countercurrent), a heat transfer fluid 44 which condenses and then optionally solidifies the product, in particular pyrophoric, in the line 43, while the vector gas and the incondensable impurities escape via the top at 45. When this line 43 is filled with product in solid form, the flow of refrigerant fluid is stopped and replaced by the flow of a heating fluid, in order to progressively liquefy the product, in particular pyrophoric, which then flows via the same line 43 and then continues downward via the lines 42 and 41 to be stored, for example, in the means 500 for storing purified liquid. The purified liquid can also be recovered and stored in the receptacle 499 fitted with a level detector 498 to enable it to pour the liquid into the storage unit 500 via the valve 497 and 201. To accelerate and improve the condensation of the product, in particular pyrophoric, it can be bubbled upon its arrival via the line 496 in the receptacle 499 (as shown in Figure 2), thereby already condensing some of the vapors present in the mixture, upon contact with the liquid.

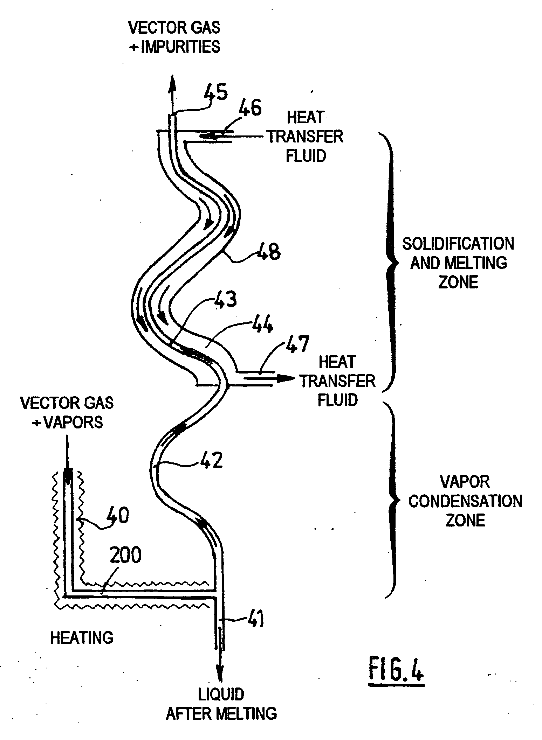

Figure 4 shows a similar system to the system in Figure 3, but wherein an upper part is provided, representing a precursor solidification and melting zone, according to the type of heat transfer fluid used, and a lower part which is simply a vapor condensation zone. The mixture inlet line 200 is heated (optional) using heating resistors, heating strips, etc. 40. The line 200 discharges on the one hand into the line 41 (in which the purified liquid flows downward), and on the other, the line 42 in which the liquid/vapor mixture flows. This line not surrounded by cooling fluid is nevertheless already cooled (indirectly by conduction) by the presence of the line 43 which continues said line upward and which is itself cooled. The vapors are condensed to liquid in this portion of line 42. In the part of line 43, the heat transfer liquid 44 flowing in the outer jacket 48 allows the condensation and/or solidification of the pyrophoric liquid inside 43. The heat transfer fluid flows here in countercurrent (co-current is also possible) to the mixture, while the vector gas (inert gas here) and optionally the impurities, are removed at 45, at the upper end of 43. After optional solidification of the product, in particular pyrophoric, in the line 43, said product is reliquefied by circulating a sufficiently hot heat transfer liquid in the jacket 48.

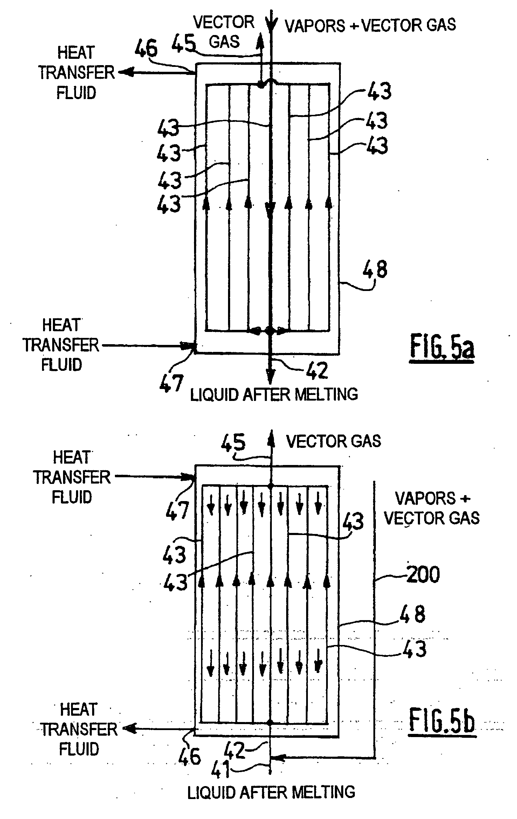

Figure 5 shows an alternative embodiment of the preceding system, in which the same elements have the same references as previously.

In Figure 5a, the heat transfer fluid is sent from the bottom and, after heat exchange, removed at the top of the heat exchanger, while the vapors and the inert gas are injected downward, at the top of the heat exchanger, the liquid being recovered at the bottom of the heat exchanger after melting, while the vector gas escapes via the top.

In Figure 5b, the system is virtually identical, with the exception of the vapors and the vector gas, which are injected via the bottom, while the heat transfer fluid is injected from the top downward.

In the unit in Figure 5, the heat exchanger may be much more compact than in Figure 4, because of the arrangement of the pipes 43, parallel to one another and connected together in their bottom and top parts.

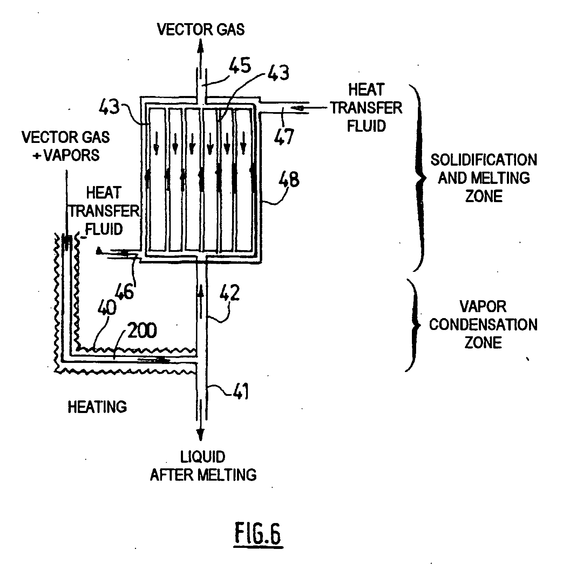

Figure 6 shows another alterative embodiment of the heat exchanger usable in the invention, which comprises (like the one in Figure 4) in its upper part, a zone of solidification and melting of the product, in particular pyrophoric (plate heat exchanger), and in its bottom part, a zone of vapor condensation. This system is similar to the one described in Figure 4, with the exception of the heat exchanger system, which operates like the one in Figure 5b. The same elements as those in the preceding figures have the same references. The mixture feed line 200 is also heated using heating sleeves 40.

Obviously, the invention also extends to the alternatives in which the "initial" liquid and the "final" liquid have substantially the same purity. One of the important points of the invention consists in fact in transporting a liquid, in particular pyrophoric, product from one point to another, under highly improved safety conditions, compared with the usual conditions for transporting these liquids, and in generally improving the purity of the "final" product.

## Claims

1. A method for distributing a liquid, in particular pyrophoric, product from a storage point (170) to a use point, **characterized in that** an inert gas is bubbled through the product in the liquid state in order to generate a mixture of inert gas and vapors of said product, the mixture is preferably routed close to the use point or to a second storage point (500), the product is separated from the gas mixture by condensation thereof, the inert gas and at least part of the impurities, in particular light, initially contained in the liquid product to be purified, being preserved in the form of waste gas.

2. The method as claimed in claim 1, **characterized in that** the product to be purified is heated.

3. The method as claimed in one of the preceding claims, **characterized in that** the mixture of inert gas and product vapors is heated during at least part of its routing.

4. The method as claimed in claim 3, **characterized in that** the mixture is essentially heated along the whole length of its route up to the separation of the product and the inert gas.

5. The method as claimed in one of the preceding claims, **characterized in that** the product contained in the gas mixture is separated from at least the inert gas using a cryogenic condensation system, a membrane and/or an adsorption system.

6. The method as claimed in claim 5, in which a cryogenic condensation system is used, **characterized in that** the separation initially takes place in a first phase, during which the product, in particular pyrophoric, in gaseous form, is liquefied and recovered.

7. The method as claimed in claim 6, **characterized in that** in a second phase, the liquid, in particular pyrophoric, product is solidified.

8. The method as claimed in either of claims 6 and 7, **characterized in that** the transition from the gas phase to the liquid and/or solid phase is carried out by passage through a heat exchanger (320).

9. The method as claimed in claim 8, **characterized in that** the cooling in the heat exchanger (320) takes place by indirect contact with a cooled heat transfer liquid using a compressor (430).

10. The method as claimed in one of the preceding claims, **characterized in that** the solidified pyrophoric product is melted to the purified pyrophoric liquid state.

11. The method as claimed in claim 10, **characterized in that** an inert gas is injected into the purified pyrophoric liquid, in order to generate a mixture of inert gas and vapors of purified pyrophoric liquid, which can be delivered immediately to the reactor.

## Patentansprüche

1. Verfahren zum Verteilen eines flüssigen, im Speziellen luftentzündlichen Produkts von einem Lagerort (170) zu einem Verbrauchsort, **dadurch gekennzeichnet, dass** ein Inertgas durch das Produkt im flüssigen Zustand geperlt wird, um ein Gemisch aus Inertgas und Dämpfen des besagten Produkts zu erzeugen, das Gemisch vorzugsweise nahe am Verbrauchsort oder an einem zweiten Lagerort (500) geleitet wird, das Produkt vom Gasgemisch durch die Kondensierung davon getrennt wird, und das Inertgas und zumindest ein Teil der im Speziellen feinen Verunreinigungen, die ursprünglich im zu reinigenden flüssigen Produkt enthalten waren, in Form von Abgas erhalten werden.

2. Verfahren nach Anspruch 1, **dadurch gekennzeichnet, dass** das zu reinigende Produkt erwärmt wird.

3. Verfahren nach irgendeinem der vorherigen Ansprüche, **dadurch gekennzeichnet, dass** das Gemisch aus Inertgas und Produktdämpfen während zumindest eines Teils seiner Weiterleitung erwärmt wird.

4. Verfahren nach Anspruch 3, **dadurch gekennzeichnet, dass** das Gemisch im Wesentlichen über die gesamten Länge seiner Weiterleitung hinweg, bis hin zur Trennung des Produkts und des Inertgases erwärmt wird.

5. Verfahren nach einem der vorherigen Ansprüche, **dadurch gekennzeichnet, dass** das im Gasgemisch enthaltene Produkt unter Verwendung eines kryogenen Kondensationssystems, einer Membran und/ oder eines Adsorptionssystems von zumindest dem Inertgas getrennt wird.

6. Verfahren nach Anspruch 5, wobei ein kryogenes Kondensationssystem verwendet wird, **dadurch gekennzeichnet, dass** die Trennung zuerst in einer ersten Phase erfolgt, in der das im Speziellen luftentzündliche und gasförmige Produkt verflüssigt und wiedergewonnen wird.

7. Verfahren nach Anspruch 6, **dadurch gekennzeichnet, dass** in einer zweiten Phase das flüssige, im Speziellen luftentzündliche Produkt verfestigt wird.

8. Verfahren nach beiden Ansprüchen 6 und 7, **dadurch gekennzeichnet, dass** der Übergang von der Gasphase in die flüssige und/ oder feste Phase durch den Durchlauf durch einen Wärmetauscher (320) erfolgt.

9. Verfahren nach Anspruch 8, **dadurch gekennzeichnet, dass** die Kühlung im Wärmetauscher (320) durch den indirekten Kontakt mit einer gekühlten Wärmeträgerflüssigkeit unter Verwendung eines Kompressors (430) erfolgt.

10. Verfahren nach einem der vorherigen Ansprüche, **dadurch gekennzeichnet, dass** das verfestigte luftentzündliche Produkt in den gereinigten luftentzündlichen flüssigen Zustand geschmolzen wird.

11. Verfahren nach Anspruch 10, **dadurch gekennzeichnet, dass** ein Inertgas in die gereinigte luftentzündliche Flüssigkeit injiziert wird, um ein Gemisch aus Inertgas und Dämpfen der gereinigten luftentzündlichen Flüssigkeit zu erzeugen, die umgehend in den Reaktor abgegeben werden kann.

## Revendications

1. Procédé pour distribuer un produit liquide, en particulier pyrophorique, d'un point de stockage (170) à un point d'utilisation, **caractérisé en ce que** des bulles d'un gaz inerte sont forcées à travers le produit dans l'état liquide afin de générer un mélange de gaz inerte et de vapeurs dudit produit, le mélange est de préférence acheminé près du point d'utilisation ou d'un second point de stockage (500), le produit est séparé du mélange gazeux par condensation de celui-ci, le gaz inerte et au moins une partie des impuretés, en particulier légères, initialement contenues dans le produit liquide destiné à être purifié, étant préservés sous forme de gaz perdu.

2. Procédé selon la revendication 1, **caractérisé en ce que** le produit destiné à être purifié est chauffé.

3. Procédé selon l'une des revendications précédentes, **caractérisé en ce que** le mélange de gaz inerte et de vapeurs de produit est chauffé durant au moins une partie de son acheminement.

4. Procédé selon la revendication 3, **caractérisé en ce que** le mélange est essentiellement chauffé sur la longueur entière de son chemin jusqu'à la séparation du produit et du gaz inerte.

5. Procédé selon l'une des revendications précédentes, **caractérisé en ce que** le produit contenu dans le mélange gazeux est séparé au moins du gaz inerte en utilisant un système à condensation cryogénique, une membrane et/ou un système d'absorption.

6. Procédé selon la revendication 5, dans lequel un système à condensation cryogénique est utilisé, **caractérisé en ce que** la séparation a initialement lieu dans une première phase, durant laquelle le produit, en particulier pyrophorique, sous forme gazeuse, est liquéfié et récupéré.

7. Procédé selon la revendication 6, **caractérisé en ce que** dans une seconde phase, le produit liquide, en particulier pyrophorique, est solidifié.

8. Procédé selon l'une ou l'autre des revendications 6 et 7, **caractérisé en ce que** la transition de la phase gazeuse à la phase liquide et/ou solide est réalisée par passage à travers un échangeur de chaleur (320).

9. Procédé selon la revendication 8, **caractérisé en ce que** le refroidissement dans l'échangeur de chaleur (320) a lieu par contact indirect avec un liquide de transfert de chaleur refroidi en utilisant un compresseur (430).

10. Procédé selon l'une des revendications précédentes, **caractérisé en ce que** le produit pyrophorique solidifié est fondu en l'état liquide pyrophorique purifié.

11. Procédé selon la revendication 10, **caractérisé en ce qu'**un gaz inerte est injecté dans le liquide pyrophorique purifié, afin de générer un mélange de gaz inerte et de vapeurs de liquide pyrophorique purifié, qui peut être fourni immédiatement au réacteur.
